# EUROPEAN PATENT SPECIFICATION

(11) **EP 1 181 571 B1**
(45) Date of publication and mention of the grant of the patent: **17.12.2008**
(21) Application number: 00935304.6
(22) Date of filing: 22.05.2000
(51) Int. Cl.: G01R 33/563

(54) **METHOD OF MAGNETIC RESONANCE IMAGING**
VERFAHREN ZUR BILDERZEUGUNG DURCH MAGNETISCHE RESONANZ
PROCEDE D'IMAGERIE PAR RESONANCE MAGNETIQUE

(30) Priority: 21.05.1999 GB 9911939; 31.03.2000 GB 0007867
(43) Date of publication of application: 27.02.2002
(73) Proprietor: GE HEALTHCARE AS, 0401 Oslo (NO)
(72) Inventor: BJØRNERUD, Atle, N-0765 Oslo (NO); BRILEY-SÆBO, Karen, New Jersey 07677 (US); KNOPP, Michael, Vinzenz, 69120 Heidelberg (DE); MCGILL, Stephen, N-0350 Oslo (NO); SCHOENBERG, Stefan, Oswald, 69120 Heidelberg (DE)
(74) Representative: Rollins, Anthony John
(86) International application number: PCT/GB2000/001960
(87) International publication number: WO 2000/072037

(56) References cited:
- WO-A-92/11037

## Description

The present invention relates to improvements in and relating to methods of magnetic resonance imaging (MRI) of the kidneys.

Renal artery stenosis, the narrowing of the artery supplying blood to the kidney, can cause two effects - hypertension and renal insufficiency. Hypertension can result in large vessel disease and complications such as myocardial infarction and central nervous system bleeding. Renal insufficiency potentially leads to end stage renal failure resulting in the necessity for lifelong dialysis and the risk of death. While renal artery stenosis is a relatively rare cause of hypertension affecting only 0.5 to 5% of the general population (see: Lewin et al., Arch. Intern. Med. 145: 424-427 (1985); Ying et al., N. Engl. J. Med. 311: 1070-1075 (1984); Swales, Lancet I: 577-579 (1976); and Arch. Intern. Med. 147: 820-829 (1987)), it has a high incidence in patients with pre-existing vascular disease. Moreover, in patients with diabetes the incidence rises to 10%, in patients with abdominal aortic aneurysms the incidence rises to over 20%, and in patients with peripheral vascular disease the incidence rises to over 40% (see: Sawicki et al., J. Intern. Med. 229: 489-492 (1991); and Missouris et al., Am. J. Med. 96: 10-14 (1994)).

Assessment of renal artery stenosis however is problematic for several reasons. Firstly, reliable detection and gradation of severity of the stenosis is required and in order to screen a large population of patients the procedure used must be safe, cost effective and accurate. Secondly, if the presence of a renal artery stenosis is detected, it is important to determine whether this is actually related to the patient's hypertension or renal insufficiency since only 10% of renal disease is due to renovascular abnormalities with the rest generally being caused by diseases of the renal parenchyma, e.g. inflammatory diseases such as glomerulonephritis. Nonetheless chronic ischemia arising from renal artery stenosis can cause pathological changes to the renal parenchyma. Thirdly, since renoparenchymal and renovascular diseases can co-exist, it is important to determine the extent to which a renal artery stenosis is contributing to the overall malfunctioning of the kidney, i.e. to determine the hemodynamic and functional significance of the stenosis. Fourthly and most importantly, it is important to determine whether the benefit to the patient's renal function from removal of a renal artery stenosis will outweigh the risks of intervention. Moreover, there is only limited capacity for surgical revascularisation of patients with renal artery stenosis and the enormous costs of dialysis and organ transplant could be significantly reduced if the most appropriate candidates for surgical revascularisation can be selected.

Until now, the "gold standard" for diagnosis of renal artery stenosis has been X-ray digital subtraction angiography (DSA). However this technique is invasive since it involves catheterisation of the aorta and exposure of the patient to ionizing radiation and to renally excreted (and hence potentially nephrotoxic) contrast media. The problem of nephrotoxicity is particularly worrying since most patients investigated already suffer from some degree of renal insufficiency. Due to these drawbacks DSA is not considered particularly useful as a general screening technique. Furthermore, DSA is not able to quantify the extent of parenchymal damage and so is limited in its ability to be used in predicting the overall outcome of renal revascularisation. Other techniques for diagnosis of renal artery stenosis exist which involve ultrasound or renal scintigraphy and are non-invasive. However while such techniques allow an assessment of renal function they do not permit accurate assessment of vascular morphology. Nonetheless, scintigraphy is currently considered to be the gold standard for measurement of renal perfusion and excretory function.

MRI has the great attractions of being non-invasive and allowing combination of multiple imaging strategies permitting both functional and morphological evaluation of the organ or tissue under investigation. While initially the emphasis in MRI was on imaging areas of the body without motion (e.g. the brain) and abdominal MRI, e.g. renal MR angiography, was subject to artefacts and not widely used, within recent years faster imaging procedures allowing image acquisition in less than a second have been developed and the area of MRI application has expanded into the chest and abdomen.

The introduction of contrast enhanced 3D MR angiography in a single breath-hold has allowed high quality angiography to be performed without the serious potential for nephrotoxicity (see: Prince et al., Radiology 197: 785-792 (1995)). The sensitivity and specificity of the technique for detection of a renal artery stenosis are now consistently reported as being about 95% (see: Hany et al., Radiology 204: 357-362 (1997); Snidow et al., Radiology 198: 725-732 (1996); Steffens et al., JMRI 7: 617-622 (1997); Bakker et al., Radiology 207: 497-504 (1998); and Wilman et al., Radiology 205: 137-146 (1997)).

This MRI technique however still suffers from various drawbacks. Firstly it is still relatively complex since, using the injectable MRI contrast agents currently commercially available (e.g. Magnevist, Omniscan or ProHance), image acquisition must be timed to coincide with the first passage of the agent through the renal arteries (for example using the technique of EP-B-656762 (Prince)) as these agents rapidly extravasate. Although a variety of techniques for automatic or semi-automatic detection of contrast agent arrival have been developed (see for example Schoenberg et al., Invest Radiol. 33: 506-514 (1998)), image acquisition timing is still a complex issue.

Secondly, the spatial resolution achievable with first pass 3D MR angiography is three to five-fold lower than that of DSA. First pass imaging requires maximum coverage of the vessels of interest in a single breath-hold and thus wastes spatial resolution.

Thirdly, MR imaging using extracellular (ECF) contrast agents, such as the soluble gadolinium monochelates that are currently commercially available, cannot absolutely quantify the amount of parenchymal damage to the kidney since the kidney does not have a blood tissue barrier and the ECF agents immediately extravasate when passing through the glomeruli. Accordingly quantification of blood volume and blood flow is not feasible.

There is thus a need for an improved method of MRI which can be used to assess both renal function and morphology.

We have now found that quantification of both the morphological degree of renal artery stenosis and the renal parenchymal perfusion can be achieved in a single MR examination if a blood pool contrast agent, i.e. a contrast agent which remains in the intravascular space during the time course of the examination is used.

Viewed from one aspect the present invention thus provides use of a blood pool MR contrast agent for the manufacture of a contrast medium for use in a method of magnetic resonance imaging of the kidney in a vascularised human or non human (e.g. mammalian, avian or reptilian) body wherein said contrast medium is administered into the vasculature of said body and images of said kidney are generated using imaging sequences and timing to permit both visualisation and gradation of renal artery stenosis and quantification of renal perfusion, and, optionally, values indicative of renal artery stenosis grade and renal perfusion are generated from said images or from detected magnetic resonance signals capable of transformation into said angiograms.

By a blood pool MR contrast agent is meant a magnetic (e.g. paramagnetic, ferromagnetic, ferrimagnetic or superparamagnetic) material capable of reducing the T₁ and/or T₂* of water protons and which if administered into the vascular space does not significantly leak out into the interstitium during the time course of the interventional or interoperative procedure, i.e. it is essentially confined to the vascular space until excreted or metabolized. Examples of such blood pool agents include polymeric chelates (e.g. cascade polymers or dendrimers carrying metallated chelate groups) and particulates, in particular iron oxides and liposomes. Generally the agent should have a blood half life of at least 5 minutes, preferably at least 30 minutes. By way of contrast, the first parenteral MR contrast agents Gd DTPA (Magnevist® from Schering), Gd DTPA-bismethylamide (Omniscan® from Nycomed Amersham) and Gd HP-D03A (ProHance®) are all extracellular fluid MR agents; they are water-soluble monochelates which following administration into the vasculature rapidly extravasate into the interstitium.

Blood pool agents of particular use in the method of this invention include low molecular weight chelates which bind to blood proteins, e.g. blood proteins such as albumin, for example DTPA or DOTA derivatised with protein binding groups, e.g. lipophilic side chains such as aromatic moieties, e.g. one or more phenyl ring systems. One such example is MS-325/Angiomark of EPIX.

Suitable polymer based contrast agents for use in the present invention can be carbohydrate or protein based, e.g. CMD-DTPA-Gd of Guerbet (Carboxymethyl dextran-GdDTPA conjugates), GdDTPA polylysine conjugates, or cascade or dendrimer polymers, e.g. Gadomer 17 of Schering AG or similar cascade polymers as described in US-A-5874061 (of Schering AG), herein incorporated by reference.

Suitable iron oxide (or doped iron oxide) based contrast agents for use in the present invention are known in the field under the name of SPIO (superparamagnetic iron oxides) or USPIO (ultrasmall superparamagnetic iron oxides). Examples include carbohydrate stabilised iron oxide particles, e.g. dextran-stabilised particles such as Combidex of Advanced Magnetics, and NC100150 (Clariscan, Nycomed Amersham).

More particularly the magnetic iron oxide contrast agent is preferably a water-dispersible material comprising magnetic iron oxide particles having on their surfaces (e.g. as a coating), an optionally modified carbohydrate or polysaccharide or derivative thereof, e.g. a glucose unit containing optionally modified polysaccharide or derivative thereof, preferably an optionally modified dextran or starch or derivative thereof, for example a cleaved (e.g. oxidatively cleaved) starch or carboxylated dextran. Such iron oxide complexes preferably also comprise a further material (e.g. coating material), especially one which inhibits opsonization, e.g. a hydrophilic polymer, preferably a functionalized polyalkylene oxide, more preferably a functionalized polyethylene glycol (PEG), in particular methoxy PEG phosphate (MPP).

The iron oxide complexes preferably have a core (i.e. iron oxide particle) diameter (mode diameter) of 1 to 15 nm, more preferably 2-10 nm, especially 3-7 nm, a total diameter (mode particle size) of 1 to 100 nm, more preferably 5-50 nm, especially preferably 10-25 nm, an r₂/r₁ ratio at 0.47T and 40°C of less than 3, more preferably less than 2.3, still more preferably less than 2.0, especially preferably less than 1.8. The saturation magnetization (Msat) at 1T is preferably 10 to 100 emu/gFe, more preferably 30-90 emu/gFe. Other particulate based systems of use in the present invention include liposomal or emulsion based agents.

Furthermore, compound 7228 of Advanced Magnetics can be used in the present invention, as can the materials described in WO 91/12025, WO 90/01899, WO 88/00060, WO 91/12526 and WO 95/05669, all to Advanced Magnetics, and those described in WO92/11037 and WO90/01295

The present invention provides the use of a blood pool MR contrast agent for the manufacture of a contrast medium for use in a method of diagnosis comprising a method of imaging.

The comprehensive morphological and functional approach to kidney imaging according to the invention can be used to guide the therapeutic strategies for patients with renal artery stenosis by establishing guidelines for revascularisation since the quantitative data generated by the method of the invention can be correlated with each other to differentiate between renovascular and renoparenchymal damage.

The blood pool contrast agent is desirably administered as a bolus, e.g. by injection or infusion into the vasculature over a short time period, preferably 1 minute or less, more preferably 5 seconds or less, most preferably 1 second or less. The bolus may be sharpened by using a saline injection chaser. Injection or infusion is preferably into a vein upstream of the kidney. Particularly preferably injection is at a site whereby bolus arrival at the kidney will occur within 60 seconds, preferably 10 to 25 seconds. If a particularly sharp bolus is desired, injection may be into the renal artery itself.

In order to quantitate tissue perfusion (in terms of organ perfusion) in units of ml blood/min/g tissue the transient effect of the contrast agent in the tissue must be observed. This is best achieved by measuring the first pass effect of the agent in the tissue after a bolus injection of the agent.

The dosage of the contrast agent used according to the invention will depend upon the species, the longitudinal relaxivity of the agent, the magnetic moment of the agent at the imaging field strength and the sequence parameters used to acquire the image.

Concentration of a blood pool contrast agent is typically 0.01 - 10 mM in blood during examination.

The blood pool contrast agent is especially preferably a superparamagnetic iron oxide, e.g. as disclosed in WO97/25073, especially one coated with a starch residue and particularly one also coated with an opsonisation inhibitor such as for example PEG. The use of such contrast agents has been described by Røhl et al. Acta Radiologica 40: 282-290 (1999). These materials are especially suitable since they combine a strong T₇* in a bolus phase with a predominant T₁ effect in the steady state. Furthermore, they remain in the vascular space during kidney transit, and they are not nephrotoxic and do not rely on renal excretion and so are particularly safe for use with patients with compromised renal function.

The MR imaging in the method of the invention preferably involves image acquisition at least two times, once during first passage of a bolus of the contrast agent through the kidney and a second after the contrast agent has become substantially uniformly distributed in the blood, e.g. after 1 to 30 minutes, preferably 3 to 15 minutes, following bolus administration of the contrast agent. Desirably the first image is T₁, T₂, or T₁*-weighted and the second T₁-weighted. Especially preferably, image generation is also affected before contrast agent administration or before arrival of the contrast agent at the kidney, i.e. a native or non-contrast enhanced image is preferably acquired.

Thus, a preferred embodiment, provides a method of MR imaging of the kidney in a vascularised human or non-human animal body, said method comprising administering into the vasculature of said body a bolus of a blood pool MR contrast agent (e.g. intravenous injection), preferably a superparamagnetic contrast agent, generating a contrast-enhanced MR image, preferably a T₂*-weighted image, of said kidney during the first pass of said contrast agent, and after the concentration of said contrast agent throughout the blood of said body has become substantially uniform generating at least one further MR image, preferably a T₁-weighted image, of said kidney, and optionally deriving from said MR images values indicative of renal perfusion and renal artery stenosis grade.

In the invention, the first pass T₂*-weighted image, which essentially provides perfusion information, can be superimposed upon the subsequent T₁-weighted image, which provides morphological information so as to permit the physician to view directly the correlation between a stenosis and a hypoperfused or non-perfused area within the kidney.

As mentioned earlier, renal hypertension or insufficiency may be caused by renal artery stenosis or by parenchymal damage. Evaluation and grading of renal artery stenosis is achievable using the present invention, in particular where the steady state images are generated from a volumetric (3D) image acquisition, enabling reconstruction in any plane and any projection within the acquired volume. Assessment of parenchymal damage can be performed according to the methods of the invention by using the first pass images to quantify intra-parenchymal blood volume. The quantitative data thus generated from the two sets of images may then be correlated with each other to enable the physician to differentiate between renovascular and renoparenchymal damage and assess the likelihood of success for interventional surgery.

Viewed from a further aspect, the invention thus provides use of a blood pool MR contrast agent for the manufacture of a contrast medium for use in a method of differentiation between renovascular damage and renoparenchymal damage in a kidney in a vascularised human or non human body wherein said contrast medium is administered into the vasculature of said body, preferably as a bolus, and images of said kidney are generated using imaging sequences and timing to permit both visualisation and gradation of renal artery stenosis and quantification of renal perfusion, and wherein the physiological and morphological state of said kidney is assessed.

While many varieties of blood pool MR contrast agents may be used, e.g. macromolecular or polymeric (e.g. dendrimeric) agents, blood protein binding agents, liposomal contrast agents and superparamagnetic iron oxides, it is particularly desirable to use the degraded starch-coated superparamagnetic iron oxides of WO97/25073. These are especially suitable for four reasons. Firstly due to the large magnetization associated with superparamagnetic particles they have predominant T₂* effects during the first pass of the bolus. Secondly, due to their low r₂/r₁ ratio, T₁ effects dominate when a steady state, i.e. when a uniform distribution within the blood pool, has been achieved. Thirdly, due to the size and surface of the particles they remain in the intravascular space during the time course of the MR examination being subject neither to glomalular filtration nor to secretion (their ultimate elimination from the intravascular space is via the reticuloendothelial system). Fourthly, they are not nephrotoxic and not renally excreted and thus are suitable for use with patients with compromised renal function.

Contrast enhanced MR angiography is preferably effected using fast spoiled gradient echo sequences with short T_{R} and T_{ε} values. A complete 3D data set with high spatial resolution can be obtained in this way because of the prolonged T₁ shortening effect and long vascular half life of the agent. To obtain MR angiograms sufficiently clear for diagnostic use, the T₁ of the blood needs to be reduced significantly - shorter T₁ of the blood, shorter T_{R}, and higher flip angle result in higher contrast between the blood vessel and the surrounding tissues which will have higher T₁ values.

Desirably the blood pool MR contrast agent is administered at dosages sufficient to achieve T₁ values in blood, at steady state, of less than 300 ms, more preferably less than 200 ms and still more preferably less than 100 ms. T₁-weighted 3D spoiled gradient echo imaging is then preferably performed with T_{R} values of 1.5 to 50 ms, more preferably 2 to 20 ms, T_{ε} values of 0.5 to 15 ms, more preferably 0.7 to 5 ms, and flip angles of 5 to 90, more preferably 10 to 60. Optionally a magnetisation preparation prepulse may be applied in order to increase the contrast between blood and surrounding tissues. The inversion time T1 should preferably be between 5 and 700 ms, more preferably between 10 and 600 ms, even more preferably between 15 and 500 ms. Although image acquisition following the prepulse is preferably a gradient echo sequence, echo planar (EPI) or RARE type acquisition schemes may also be applied. Since the blood pool MR contrast agent remains in the vasculature for a prolonged period, multiple breathold MR angiograms can be obtained. Generally one will first obtain a large volume data set with low spatial resolution and subsequently (having identified the region of interest) obtain small volume data sets with a higher spatial resolution, e.g. about 1 mm³. These may be used to grade renal artery stenosis, e.g. in steps of 20%. A grade of 0% means blood flow is unaffected, while a grade of 100% means blood flow is totally blocked. 50% can mean 50% reduction in arterial cross sectional area or 50% reduction in blood flow rate (i.e. mL/sec); for present purposes diameter is preferred. One clinically relevant grading scheme grades stenoses as 0%, less than 50%, 50 to 80%, and above 80% (see for example Hany et al. Radiology 204: 357-362 (1997), Snidow et al. Radiology 198: 725-732 (1996), Steffens et al. JMRI 7: 617-622 (1997), Bakker et al. Radiology 207: 497-504 (1996) and Wilman et al. Radiology 205: 137-146 (1997)).

In the invention grading may be effected by measuring the vessel diameter at the point of maximum narrowing and the diameter of the normal vessel distal to the stenosis. The % stenosis is then determined from these two numbers.

The images which are used to grade renal artery stenosis may be digitally post-processed to remove overlaying renal veins if these otherwise affect interpretation of the stenosis. This may be achieved by selecting a projection in the 3D data set where the artery is not obscured by the vein. A vessel tracking algorithm may also be employed to identify the arterial structures.

Quantification of renal perfusion relies on the blood pool MR contrast agent being confined to the intravascular space during the course of the MR examination. In the invention the T₂* properties of the contrast agent may be utilised in first pass imaging following bolus administration. However the T₁ properties of the contrast agent in the steady state may additionally or alternatively be used. In the T₂^{*} model, the MR signal variation in the tissue during the first pass of the contrast agent can be analysed according to any established tracer kinetic technique, e.g. using the methods of Schreiber et al. J. Cereb. Blood Flow Metab. 18: 1143 (1998) and Stritzke et al. IEEE Trans. Med. Imag. 9: 11 (1990).

For determination of blood flow per gram of tissue, the blood volume is divided by the mean transit time of the bolus, e.g. as described by Schreiber et al. in J. Cereb. Blood Flow Metals 18: 1143-1156 (1998). The mean transit time may be determined as shown in Schreiber et al. J. Cereb. Blood Flow Metab. 18: 1143 (1998), Remmp et al. Radiology 193: 637 (1994) and Stritzke et al. IEEE Trans. Med. Imag. 9: 11 (1990).

For the kidney, the renal artery (which supplies more than 99% of the blood to the kidney) may be used as the input function. A dual slice T₂* -weighted sequence is desirably used for determination of the signal curve in the input function and the tissue. One slice is positioned perpendicular to the renal artery and the other is positioned perpendicular to the long axis of the kidney. In this way a sufficient amount of renal cortex and medulla is contained within the second slice. The contrast media bolus should be as tight as possible in order to minimise the contribution of T₁ effects to the signal curve. T_{ε} is selected to be long enough to ensure T₂* weighting but not so long that signal drops right down to base line. The temporal resolution should be selected to be high enough to avoid under-sampling of the signal curve. Image acquisition time is thus preferably 5 sec or less, more preferably 2 sec or less, particular 1 sec or less. With an image acquisition time of 2 sec, 5 to 7 data points can be obtained during bolus arrival in the renal artery. Sampling (i.e. image acquisition) should preferably continue until signal has returned to base line. Additionally, image acquisition should desirably be during free-breathing since breathold alters renal artery blood flow. Data points of images with substantial motion therefore may have to be corrected by post processing or removed from the signal curve. Using this approach absolute values of cortical perfusion can be obtained. The values obtained for non-stenosed kidneys of adult foxhounds ranged between 4 and 5 mL/g/min which was in good agreement with invasively obtained and literature data.

Typically, such a T₂*-weighted (i.e. T₂-weighted) imaging sequence may require flip angle values of 5 to 90°, more preferably 10 to 60°.

Alternatively or additionally, blood volume may be accomplished by T₁ mapping in the steady state. High resolution T₁-images of the kidney and aorta are obtained and the relative change in R₁ due to the agent in a large vessel is compared to the relative change in a given tissue. The fractional difference in R₁ in tissue versus vessel is then directly related to the blood volume of the tissue, e.g. using the method of Bauer et al. Magn. Reson. Med. 35: 43-55 (1996).

The methods of the invention may desirably also involve administration of pharmacological agents which affect blood flow, e.g. vasoconstructive or vasodilating agents or blood clot dissolving agents, e.g. angioplasty (e.g. PCTA) or placement of a stent. In this way the physician can monitor the success of attempts to remove a stenosis.

A key issue in the comprehensive assessment and differentiation of renal disease is the systematic correlation of changes in renal perfusion to the morphological degree of renal artery stenosis. Thus in the Examples below, different states were simulated under controlled conditions.

In the dog model described in Example 1, different degrees of renal artery stenosis were artificially created with an invasively implanted rubber clamp. For each degree of stenosis, high-resolution MR angiograms as well as perfusion measurements were performed. The absolute values for cortical perfusion were correlated to the percentage of renal artery stenosis. For acutely induced renal artery stenoses in an otherwise healthy kidney, cortical perfusion remained constant over a large array of degrees of stenosis. Only stenoses greater than 95% caused a substantial drop in parenchymal perfusion. These results demonstrate the uniqueness of the invention in two ways. First, this comprehensive approach obtains data that does not correlate linearly to the degree of stenosis and therefore does not provide redundant but rather additional information. Second, since there is a rather abrupt change of parenchymal perfusion, the cut-off point of exceeding the autoregulative capacity can be determined. Therefore, the functional significance of a stenosis can be quantified.

In addition, the methods of the invention were evaluated in chronic disease states. In patients with different degrees of renal artery stenosis, bilateral perfusion measurements were performed and the absolute values of cortical perfusion were correlated to the morphologic degree of renal artery stenosis obtained in the MR angiograms. By combined analysis of the morphologic and functional MR data, the following different disease states could be identified and differentiated based on the quantitative data:
- Low perfusion states with coexisting normal low-grade stenosis. This combination is caused by underlying primary renoparenchymal damage.
- Normal perfusion states with low-grade, functionally non-significant stenoses.
- Low perfusion states caused by the long presence of high-grade functionally significant stenoses.

The invention will now be illustrated further by the following non-limiting Examples and the accompanying drawings, in which:
Figure 1a shows contrast-enhanced MR angiograms obtained for different degrees of arterial stenosis (open arrow) in the same dog (left: no stenosis, middle: moderate (70%) stenosis, right high-grade (90%) stenosis);
Figure 1b shows T₂* weighted perfusion images corresponding to each image in Fig 1a during peak arrival of the contrast agent bolus;
Figure 2a shows a contrast-enhanced MR angiogram revealing low-grade (∼50%) stenosis (open arrow);
Figure 2b shows T* weighted perfusion images at peak arrival of the contrast agent bolus, revealing decreased perfusion in the left kidney (Fig 2b.1) and normal cortical perfusion in the right kidney (Fig 2b.2);
Figure 3 shows signal-time curves for the left (Fig 3a) and right (Fig 3b) kidney, corresponding to the images of Fig 2b.1 and 2b.2 respectively, showing input functions obtained in the left and right renal artery (dotted lines) and the resulting response curve in the corresponding cortical tissue (solid lines).

### Example 1

### Systematic correlation of the morphologic degree of stenosis to the corresponding perfusion changes in dogs

This Example demonstrates the systematic correlation between morphologic degree of stenosis and corresponding functional in terms of perfusion using both dynamic first pass and steady state imaging.

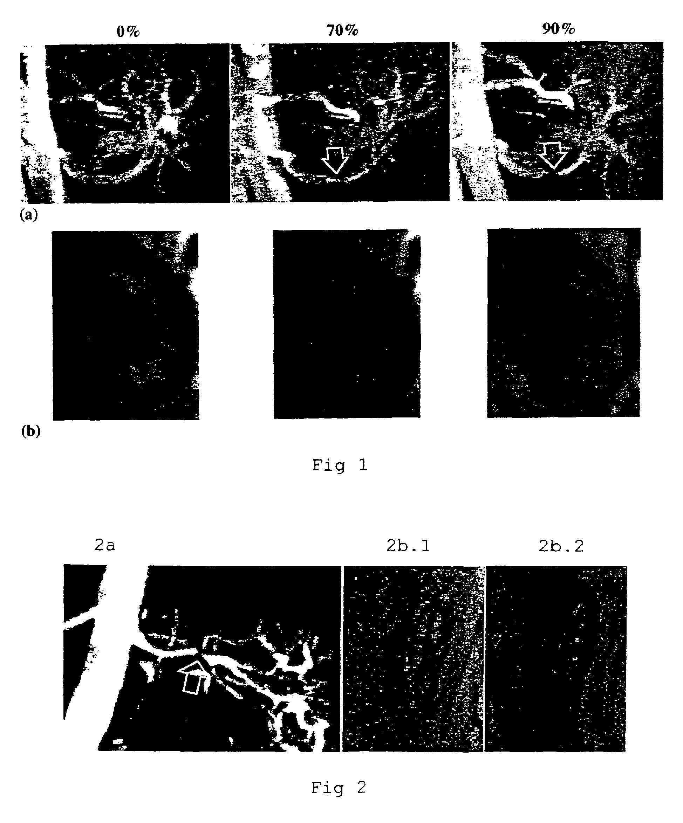

In a foxhound dog (weight approximately 30 kg) different degrees of renal artery stenosis were created by a rubber clamp, which was implanted around the renal artery. Angiographic and perfusion data were obtained using,
- bolus application of 1.5 ml of a 30 mg Fe/ml suspension of a superparamagnetic iron oxide prepared according to the description of Example 12 of WO97/25073, administered into the jugular vein at 5 mL/second,
- dynamic T₂*-weighted perfusion imaging during first pass of the bolus for quantification of cortical blood flow (see Fig. 1b of the accompanying drawings),
- high-resolution contrast-enhanced MR angiography in the steady state (see Fig. 1a),
- estimation of the cortical blood volume in the steady state.

The images were recorded on a Siemens Vision 1.5T MR imaging apparatus using the following sequences:
The following results were obtained:
   - In the high-resolution contrast-enhanced MR angiograms with a voxel size of 0.7 x 1.0 x 0.7mm, the different degrees of stenosis can be accurately identified as shown here for a non-stenosed artery (0%), a moderate stenosis (70%) and a high-grade stenosis (90%).
   - The T₂* weighted images obtained during first pass reveal specific findings for the different degrees of stenosis. In the non-stenosed (0%) vessel, a normal corticomedullar differentiation is found with massive signal loss in the cortex during peak arrival of the bolus. Only minor changes in the medulla are present as a result of overall much lower perfusion. Mean flow was calculated as 4.2 ± 1.1 ml per gram of cortical tissue per minute. For the moderate stenosis, no apparent changes in renal perfusion are visible. Cortical perfusion stays constant. This indicates that at least in the acute state the autoregulation of the kidney still is able to maintain adequate perfusion, therefore this stenosis reveals no functional significance. For the high-grade stenosis (90%), a substantial drop in cortical perfusion is found with loss of corticomedullar differentiation. Absolute cortical perfusion drops down to 2.1 ± 0.6 ml/g/min. This indicates that the cut-off point of the autoregulative capacity has been exceeded for this degree of stenosis. The blood volume required for absolute quantification of the cortical blood flow can be also calculated in the steady state by means of T₁ measurements in the renal parenchyma and the aorta. This can be done for example using a saturation recovery gradient echo sequence (c) with varying inversion times, but this strategy is not limited to this particular technique.
A T₁*-weighted FLASH sequence was used with the following sequence parameters :T_{F}=15 ms, T_{F}=6 ms, flip angle=12 deg, FOV=200x200 mm, slice thickness=5 mm, scan time =1.92 secs. One slice was used to track the bolus passage of the agent in renal parenchyma, whereas the second slice was positioned perpendicular to the renal artery to measure the arterial input function (AIF). Signal-time-curves were converted to concentration-time curves according to an exponential relationship (see Schreiber et al. and Remmp et al. (both supra)). The tissue curves were deconvoluted with the AIF using a method based on the AIF by orthogonal functions (see Schreiber et al. and Stritzke et al. (both supra)).
According to the principles of indicator dilution theory, the region blood volume (rBV), regional blood flow (rBF) and mean transit time (MTT) were calculated in RIO's (150 to 280 pixel each) lying in the renal cortex and the medulla (see Schreiber et al., Remmp et al. and Stritzke et al. (all supra)).
The morphologic degree of stenosis, defined as the percent change in artery diameter, was determined in the steady state. An additional 4.5 ml of the 30 mg Fe/ml suspension of the superparamagnetic iron oxide prepared according to the description of Example 12 of WO97/25073 was injected prior to imaging so that the total dose was 4.0 mg Fe/kg. Images were obtained using T₁-weighted 3D FEE sequences.

### Example 2

### Differentiation of renovascular and renoparenchymal disease in human patients

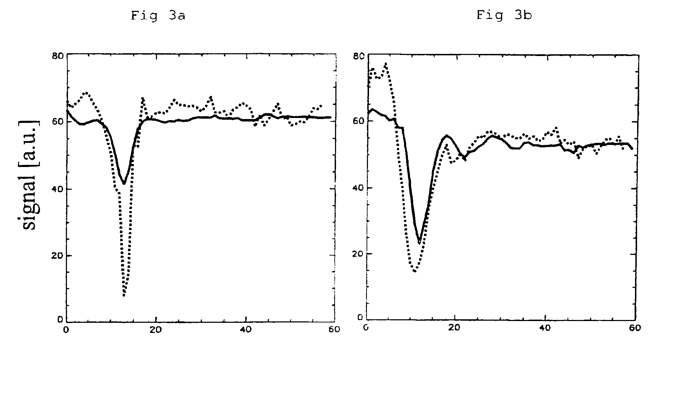

The comprehensive approach demonstrated in Example 1 was applied to a human subject and this differentiation of renoparenchymal damage from renovascular disease could be made based on the combined analysis of the angiographic and perfusion data. The patient presented with hypertension resistant to therapy and rising creatinine. The contract -enchanced MR angiography performed in the steady state revealed only a low-grade stenosis of about 50% in the distal left renal artery (see Figure 2 (a)), which was confirmed by conventional X-ray digital subtraction angiography. However, the dynamic T₁* perfusion measurements demonstrated a dramatic decrease in cortical perfusion of the left kidney with loss of corticomedullar differentiation (see Figure 2(b.1)). Calculated mean cortical flow was only 1.8 ± 0.7 ml/g/ min (see Figure 3(a)). The normal right kidney revealed a cortical blood flow of about 4.2 ± 0.9 ml/g/min (see Figures 2(b.2) and 3(b)). The substantially smaller response of the left cortex can be seen by comparison of left (Fig 3a) and right (Fig 3b) response curves (solid lines). These findings were confirmed by Tc-99-MAG3-scintigraphy, which showed only 23% of the left kidney function remaining compared to 77% of the right kidney function. Based on these findings, the diagnosis of an underlying renoparenchymal damage could be established with coexistence of a non-functionally significant renal artery stenosis. Based on the comprehensive MR information the patient did not undergo surgery.

## Claims

1. Use of a blood pool MR contrast agent for the manufacture of a contrast medium for use in a method of magnetic resonance imaging of the kidney in a vascularised human or non human body wherein said contrast medium is administered into the vasculature of said body and images of said kidney are generated using imaging sequences and timing to permit both visualisation and gradation of renal artery stenosis and quantification of renal perfusion, and, optionally, values indicative of renal artery stenosis grade and renal perfusion are generated from said images or from detected magnetic resonance signals capable of transformation into said angiograms.

2. Use of a blood pool MR contrast agent for the manufacture of a contrast medium for use in a method of differentiation between renovascular damage and renoparenchymal damage in a kidney in a vascularised human or non human body wherein said contrast medium is administered into the vasculature of said body and images of said kidney are generated using imaging sequences and timing to permit both visualisation and gradation of renal artery stenosis and quantification of renal perfusion, and wherein the physiological and morphological state of said kidney is assessed.

3. Use according to claim 1 or claim 2 wherein said blood pool MR contrast agent is a superparamagnetic contrast agent.

4. Use according to any of claims 1 to 3 wherein said blood pool MR contrast agent comprises magnetic iron oxide particles having on their surfaces an optionally modified polysaccharide and optionally a material which inhibits opsonization.

5. Use according to any of claims 1 to 4 wherein said blood pool MR contrast agent comprises superparamagnetic iron oxide particles having on their surfaces degraded starch and optionally a functionalised PEG.

6. Use according to any of claims 1 to 5 wherein said contrast medium is administered as a bolus.

7. Use according to claim 6 wherein a contrast enhanced image of said kidney is generated during the first pass of said contrast medium.

8. Use according to 7 wherein said image is a T₂*-weighted image.

9. Use according to any of claims 6 to 8 wherein at least one further image of said kidney is generated after the concentration of said contrast agent throughout the blood of said body has become substantially uniform.

10. Use according to claim 9 wherein at least one T₁-weighted image is generated after the concentration of said contrast agent throughout the blood of said body has become substantially uniform.

11. Use according to claim 9 or claim 10 comprising at least one further administration of said contrast medium.

12. Use according to any of claims 1 to 11 wherein values indicative of renal perfusion and renal artery stenosis grade are derived from said MR images.

## Patentansprüche

1. Verwendung eines Blutpool-MR-Kontrastmittels zur Herstellung eines Kontrastmediums zwecks Gebrauchs in einem Verfahren zur Magnetresonanzbildgebung der Niere in einem vaskularisierten menschlichen oder nicht menschlichen Körper, wobei das Kontrastmedium in das Gefäßsystem des Körpers verabreicht wird und Bilder der Niere unter Einsatz von Bildgebungssequenzen und -timing erzeugt werden, um sowohl die Visualisierung und Gradation einer Nierenarterienstenose als auch die Quantifizierung der Nierenperfusion zu ermöglichen, und wobei gegebenenfalls Werte, die den Grad von Nierenarterienstenose und Nierenperfusion anzeigen, anhand der Bilder oder anhand detektierter Magnetresonanzsignale erzeugt werden, die sich zu den Angiogrammen umformen lassen.

2. Verwendung eines Blutpool-MR-Kontrastmittels zur Herstellung eines Kontrastmediums zwecks Gebrauchs in einem Verfahren zur Unterscheidung zwischen renovaskulärer Schädigung und renoparenchymaler Schädigung in einer Niere in einem vaskularisierten menschlichen oder nicht menschlichen Körper, wobei das Kontrastmedium in das Gefäßsystem des Körpers verabreicht wird und Bilder der Niere unter Einsatz von Bildgebungssequenzen und -timing erzeugt werden, um sowohl die Visualisierung und die Gradation von Nierenarterienstenose als auch die Quantifizierung der Nierenperfusion zu ermöglichen, und wobei der physiologische und morphologische Zustand der Niere beurteilt wird.

3. Verwendung nach Anspruch 1 oder 2, wobei das Blutpool-MR-Kontrastmittel ein superparamagnetisches Kontrastmittel ist.

4. Verwendung nach einem der Ansprüche 1 bis 3, wobei das Blutpool-MR-Kontrastmittel magnetische Eisenoxidteilchen umfasst, die auf ihren Oberflächen ein gegebenenfalls modifiziertes Polysaccharid und gegebenenfalls ein Material aufweisen, welches Opsonisierung inhibiert.

5. Verwendung nach einem der Ansprüche 1 bis 4, wobei das Blutpool-MR-Kontrastmittel superparamagnetische Eisenoxidteilchen umfasst, die auf ihren Oberflächen abgebaute Stärke und gegebenenfalls ein funktionalisiertes PEG aufweisen.

6. Verwendung nach einem der Ansprüche 1 bis 5, wobei das Kontrastmedium als Bolus verabreicht wird.

7. Verwendung nach Anspruch 6, wobei ein kontrastverstärktes Bild der Niere während der ersten Passage (first pass) des Kontrastmediums erzeugt wird.

8. Verwendung nach Anspruch 7, wobei das Bild ein T₂*-gewichtetes Bild ist.

9. Verwendung nach einem der Ansprüche 6 bis 8, wobei zumindest ein weiteres Bild der Niere erzeugt wird, nachdem die Konzentration des Kontrastmittels im gesamten Blut des Körpers im Wesentlichen einheitlich geworden ist.

10. Verwendung nach Anspruch 9, wobei zumindest ein T₁-gewichtetes Bild erzeugt wird, nachdem die Konzentration des Kontrastmittels im gesamten Blut des Körpers im Wesentlichen einheitlich geworden ist.

11. Verwendung nach Anspruch 9 oder 10, umfassend zumindest eine weitere Verabreichung des Kontrastmediums.

12. Verwendung nach einem der Ansprüche 1 bis 11, wobei Werte, die den Grad von Nierenperfusion und Nierenarterienstenose anzeigen, aus den MR-Bildern hergeleitet werden.

## Revendications

1. Utilisation d'un agent de contraste de RM de zone d'accumulation sanguine pour la fabrication d'un milieu de contraste à utiliser dans un procédé d'imagerie par résonance magnétique du rein sur un corps vascularisé humain ou non humain dans laquelle ledit milieu de contraste est administré dans le système vasculaire dudit corps et des images dudit rein sont produites en utilisant des séquences d'imagerie et la programmation afin de permettre la visualisation et la progression de la sténose de l'artère rénale et la quantification de la perfusion rénale, et, en variante, des valeurs représentatives d'un niveau de sténose de l'artère rénale et de la perfusion rénale sont produites à partir desdites images ou à partir desdits signaux de résonance magnétique détectés pouvant se transformer en lesdits angiogrammes.

2. Utilisation d'un agent de contraste de RM de zone d'accumulation sanguine pour la fabrication d'un milieu de contraste à utiliser dans un procédé de différentiation entre des lésions réno-vasculaires et des lésions du parenchyme rénal sur un rein dans un corps vascularisé humain ou non humain dans laquelle ledit milieu de contraste est administré dans le système vasculaire dudit corps et des images dudit rein sont produites en utilisant des séquences d'imagerie et la programmation afin de permettre à la fois la visualisation et la progression de la sténose de l'artère rénale et la quantification de la perfusion rénale, et dans laquelle l'état physiologique et morphologique dudit rein est obtenu.

3. Utilisation selon la revendication 1 ou la revendication 2 dans laquelle ledit agent de contraste de RM de zone d'accumulation sanguine est un agent de contraste super-paramagnétique.

4. Utilisation selon l'une quelconque des revendications 1 à 3, dans laquelle ledit agent de contraste de RM de zone d'accumulation sanguine comprend des particules d'oxyde de fer magnétiques comportant sur leurs surfaces un polysaccharide éventuellement modifié et, en variante, un matériau qui inhibe l'opsonisation.

5. Utilisation selon l'une quelconque des revendications 1 à 4, dans laquelle ledit agent de contraste de RM de zone d'accumulation sanguine comprend des particules d'oxyde de fer super-paramagnétique comportant, sur leurs surfaces, de l'amidon dégradé et, en variante, un PEG fonctionnalisé.

6. Utilisation selon l'une quelconque des revendications 1 à 5 dans laquelle ledit milieu de contraste est administré sous forme de dose.

7. Utilisation selon la revendication 6, dans laquelle une image de contraste amélioré dudit rein est produite au cours du premier passage dudit milieu de contraste.

8. Utilisation selon la revendication 7, dans laquelle ladite image est une image pondérée en T₂*.

9. Utilisation selon l'une quelconque des revendications 6 à 8, dans laquelle au moins une autre image dudit rein est produite après que la concentration dudit agent de contraste sur l'ensemble du sang dudit corps soit devenue sensiblement uniforme.

10. Utilisation selon la revendication 9, dans laquelle au moins une image pondérée en T₁ est produite après que la concentration dudit agent de contraste sur l'ensemble du sang dudit corps soit devenue sensiblement uniforme.

11. Utilisation selon la revendication 9 ou la revendication 10, comprenant au moins une administration supplémentaire dudit milieu de contraste.

12. Utilisation selon l'une quelconque des revendications 1 à 11, dans laquelle des valeurs représentatives de la perfusion rénale et du niveau de sténose de l'artère rénale sont déduites desdites images de RM.
